(19) Europäisches Patentamt
European Patent Office
Office européen des brevets

(11) Publication number: **0 123 954**
**B1**

(12) **EUROPEAN PATENT SPECIFICATION**

(45) Date of publication of patent specification: **02.08.89**

(51) Int. Cl.$^4$: **H 05 K 1/03**

(21) Application number: **84103716.1**

(22) Date of filing: **05.04.84**

(54) **Structure containing a layer consisting of polyimide and an inorganic filler and method for producing such a structure.**

(30) Priority: **29.04.83 US 489878**

(43) Date of publication of application:
**07.11.84 Bulletin 84/45**

(45) Publication of the grant of the patent:
**02.08.89 Bulletin 89/31**

(84) Designated Contracting States:
**DE FR GB**

(56) References cited:
**EP-A-0 030 641**
**DE-B-2 413 158**
**FR-A-2 128 376**
**US-A-3 615 913**
**US-A-4 246 147**

**The Multilayer Printed Circuit Board Handbook, J.A. Scarlett, Electrochemical Publications Ltd., 1985, p. 63**

(73) Proprietor: **International Business Machines Corporation**
**Old Orchard Road**
**Armonk, N.Y. 10504 (US)**

(72) Inventor: **Bakos, Peter**
**11538 Spicewood Parkway**
**Austin, TX 78750 (US)**
Inventor: **Darrow, Russel E.**
**P.O. Box 381**
**Endicott, NY 13760 (US)**
Inventor: **Franchak, Nelson P.**
**Smith Road**
**Binghamton, NY 13905 (US)**
Inventor: **Funari, Joseph**
**149 Meeker Road**
**Vestal, NY 13850 (US)**

(74) Representative: **Louet Feisser, Arnold et al**
**Intellectual Property Department IBM Nederland**
**N.V. Watsonweg 2**
**NL-1423 ND Uithoorn (NL)**

**EP 0 123 954 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

Field of the Invention

The invention relates to a structure combining metal circuitry and a dielectric consisting of polyimide and an inorganic filler and to a method for producing such a structure.

Background of the Invention

Structures including layers of polyimide are known. Polyimide is a material which due to its dielectric properties and its chemical and mechanical resistance is attractive for many applications. It is also known to adapt the properties of polyimide for special purposes by blending a filler into the polyimide.

In the article "Screenable Alpha Particle Barrier", published in the IBM Technical Disclosure Bulletin, Vol. 23, No. 12, May 1981, p. 5281 is described that a solution containing a polyamic acid and boron nitride particles is screen on substrates to form an alpha particle barrier. The boron nitride particles, which are in the form of platelets also act as a thermally conducting material to increase heat transfer.

The article "Screened Multilayer Polyimide", published in the IBM Technical Disclosure Bulletin, Vol. 23, No. 1, June 1980, p. 109, teaches the formulation and use of a screenable adherent polyimide paste with low flow characteristics. In this paste graphite is used as a filler acting as a sponge to absorb the solvent in which the polyamic acid is dissolved. Thus, the graphite prevents excessive bleedout of the polyimide precursors and undesired flow. In use the paste is screened on a clean dry substrate and then cured at 350°C. Such a graphite-filled polyimide can be used to form a resistive layer or capacitive layer. If desired, such formed resistive layrs can have metallization either evaporated or sputtered thereon.

EP—A—30,641 describes a blanket or selective coating consisting of polyimide and mica platelets. To produce the coating a solution of a polyamic acid containing the mica platelets is applied to a substrate either uniformly or through a screen having a desired pattern. The solvent is removed and the resulting layer is cured to a solid adhering coating. The coating is preferably used to insulate current-carrying metal patterns exposed on ceramic substrates onto which silicon chips with integrated circuits are mounted.

U.S. Patent 3,615,913 describes polyimide and polyamide-polyimide coatings used as passivators for semiconductor surfaces and the production of such coatings. The coating contains a filler which consists of an electrically insulating material selected from the group of aluminum oxide, silicon oxide, glass fibers, boron nitride, quartz, mica, magnesium oxide and reactivated polytetrafluorethylene.

U.S. Patent 4,246,147 describes the composition, the application by screening, the usage and the stripping of a solder mask. The screenable and strippable solder mask composition contains a polyexpoxide or polyimide/amide, a detackifier, a high temperature resistant filler and a solvent. The applied solder mask protects predetermined areas on a substrate from the solder deposition. It is essential for the solder mask that it is readily strippable after its use. The solid filler must be one which is resistant to exposure to elevated temperatures. Examples of some suitable solid temperature resistant fillers include inter alia zinc oxide and alumina.

A multilayer structure, comprising on a substrate at least two layers of interconnected metal circuitry with a polyimide dielectric layer therebetween containing via holes, is described in "The multilayer printed circuit board handbook" edited by J. A. Scarlett, Electrochemical Publications Limited, 1985, at page 63.

Summary of the Invention

It is the object of the present invention to provide on a substrate a structure including at least two layers of interconnected metal circuitry with a polyimide based dielectric layer therebetween containing via holes and having excellent adhesive characteristics.

It is a further object of the invention to provide a dielectric layer being located between layers of interconnected metal circuitry and having closely spaced via holes with a diameter in the order of 25 µm.

It is a further object of the invention to provide the dielectric layer having the favourable physical and chemical properties of polyimide.

It is also an object of the invention to provide a method for producing a substrate a structure including at least two layer of interconnected metal circuitry with a polyimide based dielectric layer therebetween containing via holes.

It is a further object of the invention to provide a method to produce a polyimide based dielectric layer with a pattern of closely spaced small via holes reproducibly within small tolerances on a substrate with a layer of metal circuitry thereon.

It is a further object of the invention to provide a method for producing a structure with at least two layers of metal circuitry and a polyimide based dielectric layer therebetween being suitable for large scale manufacturing operation.

These objects are achieved according to the present invention, as claimed, by a multilayer structure comprising on a substrate at least two interconnected layers of metal circuitry having therebetween as a dielectric a composition containing a polyimide and aluminum oxide or zinc oxide or mixtures thereof, wherein the metal:polyimide layer thickness ratio does not exceed 1:2, and the polyimide layer has a planar top surface, and by a method for producing a multilayer structure comprising at least two interconnected layers of metal circuitry having therebetween a polyimide based dielectric layer containing via holes, characterized by the following process steps:

blanket screen printing a mixture containing a polyamido carboxylic acid, aluminum oxide or zinc oxide or mixtures thereof and a detackifier with the rest being a solvent, like N-methyl-2-pyrrolidone, on a substrate with a layer of metal circuitry thereon, the molecular weight of the polyamido carboxylic acid being in the range from about 500 to about 2500,

drying the deposited layer at a temperature between 75 and 120°C,

applying a photoresist mask,

selectively etching holes into the deposited layer at places where vias between adjacent layers of metal circuitry are needed,

baking at about 210°C before stripping the mask,

curing the deposited layer at a temperature between about 300 and 400°C and

forming another layer of metal circuitry.

The dielectric layer in the structure according to the invention is — provied the metal:polyimide thickness ratio does not exceed about 1:2 — planar. The $Al_2O_3$ and ZnO increases the mechanical and thermal stability and the heat conductivity of the dielectric layer. The indicated properties are essential for the material to be used for the dielectric layer between two layers of metal circuitry especially if these layers are miniaturised and have closely spaced metal lines.

The prior art gives no suggestion to use the $Al_2O_3$ or ZnO containing polyimide in the described way and due to the complexity of the problem to be solved the solution found is by no means obvious in view of the prior art. This also — and even more so — is true for the method according to the invention. The prior art gives no suggestion to use a screenable composition containing a polyimide precursor and a filler which undergoes a photolithographic etching step after it is applied. In the method according to the invention the dielectric layer has to be applied by screen printing in order to get the required homogeneity of the layer thickness over the metallized areas or not metallized areas respectively.

A homogeneous layer thickness is necessary in the first place to avoid pinholes in the dielectric layer. However due to the small size of the via holes it would be very difficult to form the via holes in the screening process. Therefore the via holes have to be produced by an etching process. However, there the problem arises: on the one side, to make the composition screenable it must have a consistency such that its subsequent treatment is difficult unless it is dried. On the other side, in this drying step the imidization of the polyamido carboxylic acid contained in the screenable composition tends to proceed, and if the imidization has proceeded too far the etching of the composition is not possible any more. The method according to the invention is however practicable because the $Al_2O_3$ and the ZnO suppress the imidization. This not only maintains the etchability of the layer material, but also guarantees — together with the known reproducibility within small tolerances inherent to photolithographic etch processes — a uniform etch rate over the whole substrate.

This uniform etc rate is the one prerequisite for achieving uniform via hole dimensions. The other prerequisite is the homogeneity of the layer thickness, which — as explained above — is achieved by the screen printing. So only the unique combination of screen printing, a drying process not essentially affecting the degree of cure of the polyimide and the photolithographic etch process guarantees the reproducible forming of a pattern of closely spaced small via holes. This combination is by no means suggested by the prior art.

Advantageous embodiments of the inventive structure and the inventive method are disclosed in the subclaims.

Description of the Preferred Embodiment

The invention will become more apparent from the following detailed description.

The structure according to the invention is based on a substrate consisting for example of a ceramic or a semiconducting material. The following description is restricted to a structure based on a ceramic substrate. It is pointed out however that the substrate material is not critical for the structure according to the invention and that the details of the structure could be as well explained with regard to a structure being formed for example on a semiconductor chip.

The substrate consists of a square ceramic plate have a length of a side of preferably 24 to 36 mm. On this plate a metal circuitry is formed preferably consisting for example of a bottom layer of chromium with a thickness in the order of 80 nm, a middle layer of copper with a thickness in the order of up to 4 µm and an upper layer of chromium with a thickness in the order of 80 nm. The metal circuitry and the substrate areas exposed between the metal lines are covered by a dielectric layer. The thickness of the dielectric layer in the areas between the metal lines is between about 2.5 µm and about 250 µm and preferably about 25 µm. Provided the metal circuitry:dielectric layer thickness ratio does not exceed 1:2 the surface of the dielectric layer is completely planar. The dielectric layer consists of cured polyimide and $Al_2O_3$ or ZnO or a mixture of these two compounds as a filler.

A typical representative of the polyimides has the following general formula:

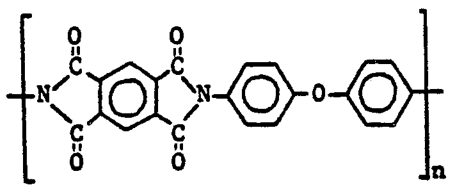

in which n is an integer of at least 5.

The filler in the form of particles is homogeneously mixed with the polyimide. The size of the filler particles can vary between 0.25 to about 10 µm and is preferably 0.5 µm. The polyimide:filler ratio is between 4:6 and 6:4 with the optimum being 1:1. With an increasing amount of filler the dielectric properties are degraded and the thermal conductivity increases. A decreasing amount of filler effects the opposite results. At a 1:1 weight ratio of filler to polyimiude the dielectric quality of the layer is still very satisfactory and its heat conductivity is high enough that the heat transfer from the structure according to the invention is sufficient to keep its temperature at a low level under operational conditions.

The dielectric layer contains a pattern of via holes. The via holes have at their lower edge preferably a diameter of about 25 to about 50 µm and their diameter at their upper edge is up to 100 µm. The optimum taper of the via hole walls is about 45°. The via holes have uniform dimensions.

On top of the dielectric layer is a second layer of metal circuitry preferably consisting of the same materials and exhibiting the same layer thickness as the metal circuitry deposited on the substrate. The two layers of metal circuitry are interconnected through said via holes. The structure described so far can be covered by a passivating layer which consists for example of sputtered quartz, a polymer or the same material as the dielectric layer, i.e. the filled polyimide. It is however also possible that a third, a fourth or even more layers of metal circuitry which are interconnected with their adjacent layers of metal circuitry, and the required dielectric layers therebetween which are basically the same as the one described above are deposited on said structure.

Often structures with multilayer circuits are susceptible to shorts or near-shorts that cause early fallouts in the field. This problem is due to the difficulty to keep the surface of multilayer structures planar which becomes more and more critical with the increasing numbers of metal layers. This problem does not arise with the structure according to the invention since each of the dielectric layers has independently from the structure underneath a planar surface which is achieved with the method according to the invention described below in detail.

The structure according to the invention has a high heat conductivity, an extraordinary physical and thermal stability, corresponds within small tolerances to the predetermined dimensions, e.g. concerning the layer thicknesses and the shape of the via holes, and the adherence of the dielectric layer or layers to the adjacent layers of metal circuitry is excellent.

The screenable composition used for producing a structure especially according to the invention contains a film-forming polymer portion in the form of a liquid composition, a detackifier, and a solid filler.

The film-forming polymer portion of the composition includes a polyimide/amide polymer. The polymer portion of the composition must be in the form of a liquid composition. Accordingly, the polymer portion is a solution or dispersion of the polyimide/amide in a non-reactive diluent.

The polyimide/amide polymers employed according to the prsent invention are well known and are available commercially. Such are sometimes referred to in the literature as polyamides or polyimido-acids and are actually non-fully cured polymers which contain varying amounts of amide and imide groupings along the polymer chain. The imide groups are obtained by condensation of the amide form with an acid group of the polymer chain. Such polymers are generally prepared by reacting at least one diamine with at least one polycarboxylic acid and/or anhydride thereof and/or ester thereof. Suggestions of various polyimide/amides can be found in U.S. Pat. Nos. 2,710,853; 2,712,543; 2,713,447; 2,880,230; 3,037,966; 3,073,784; 3,073,785; 3,179,631; 3,179,632; 3,179,633; 3,179,634; 3,179,635; and 3,190,856.

The preferred polyimide/amide polymers employed according to the present invention are those obtained by reacting an aromatic diamine with an aromatic tetracarboxylic acid dianhydride.

Examples of some anhydrides employed in preparing the polyimide/amide are pyromellitic dianhydride; mellitic anhydride; trimellitic anhydride; 2,3,6,7-naphthalene tetracarboxylic dianhydride; 1,2,5,6-naphthalene tetracarboxylic dianhydride; 3,3',4,4'-diphenyltetracarboxylic dianhydride; 2,2',3,3'-diphenyltetracarboxylic dianhydride; 3,3',4,4'-diphenylmethane tetracarboxylic dianhydride; bis(3,4-carboxyphenyl)ether dianhydride; bis(2,3-dicarboxyphenyl)sulfone dianhydride; 3,3',4,4'-benzophenone tetracarboxylic dianhydride; 3,3',4,4'-stilbenetetracarboxylic dianhydride; 2,3,6,7-anthracenetetracarboxylic dianhydride; 1,2,7,8-phenanthrenetetracarboxylic dianhydride; 2,3,6,7-naphthacenetetracarboxylic dianhydride; 2,3,8,9-chrysene tetracarboxylic dianhydride; 2,3,6,7-triphenylene tetracarboxylic dianhydride; pyrene-4,5,9,10-tetracarboxylic dianhydride; perylene-3,4,9,10-tetracarboxylic dianhydride; and coronene-1,2,7,8-tetracarboxylic dianhydride.

Examples of some aliphatic organic diamines are ethylenediamine; N-methylethylenediamine; trimethylenediamine; tetramethylenediamine; 1,5-diaminopentane; hexamethylenediamine; 1,4-diaminocyclohexane; 1,3-diaminocyclopentane; 1,3-diamino-2-methylpropane; 1,6-diamino-4-methylhexane; 1,4-diamino-2-methylbutane; 1-(N-propylamino)-6-aminohexane; and 1,3-diamino-2-phenylpropane.

Examples of some aromatic-aliphatic diamines are para-aminophenylmethylamine, and meta-aminophenylmethylamine.

Examples of some aromatic organic diamines are 2,2-di(4-aminophenyl)-propoane; 4,4′-diaminodiphenylmethane; benzidine; mono-N-methylbenzidine, 3,3′-dichlorobenzidine; 4,4′- diaminodiphenylsulfide; 3,3′-diaminodiphenylsulfone; 4,4′-diaminodiphenylsulfone; 4,4′-diaminodiphenylether; 1,5-diaminonaphthalene; meta-phenylenediamine; paraphenylenediamine; 3,3′-dimethyl-4,4′-biphenyldiamine; 3,3′-dimethoxybenzidine; 1-isopropyl-2,4-phenylenediamine; 3,5-diamino orthoxylene; 3,5-diaminodiphenyl; 1,3-diaminonaphthalene; 2,6-diamino anthracene; and 4,4′-diaminostilbene. The most preferred aromatic diamines are 4,4′-diaminodiphenylether, 4,4′-diaminodiphenylmethane and paraphenylenediamine.

The polyimide/amides employed according to the present invention generally have molecular weights from 500 to 2500, and when combined with just the diluent preferably have a viscosity of about 0.025—0.15 Pa.s at normal room temperature (e.g. 25°C). The polyimide/amides are in the form of solid polymeric materials and, accordingly, are admixed with an inert diluent.

Examples of some inert diluents which do not react with the diamines or dianhydrides employed to prepare the polyimide/amides or react with the product include organic polar solvent which have a dipole moment whose functional groups do not react with the precursors (e.g. the diamines or the dianhydrides). Examples of some suitable organic polar solvents include N,N-dimethylformamide, N,N-dimethylacetamide, N-methyl-2-pyrrolidone, N,N-diethylformamide, N,N diethylacetamide, N,N-dimethylmethoxyacetamide, dimethylsulfoxide, diethylsulfoxide, pyridine, dimethylsulfone, diethylsulfone, dipropylsulfone, hexamethylphosphoramide, tetramethylenesulfone, dimethyltetramethylenesulfone, and dimethoxytetramethylenesulfone. Mixtures of diluents can be employed when desired.

The screenable and etchable dielectric layer composition of the present invention also includes a solid filler, which modifies some of the properties of polyimide, like e.g. its heat conductivity, its mechanical and thermal stability, its adherence and curability. Suitable solid fillers include zinc oxide, and alumina. The filler employed generally has a particle size of about 0.25 to 10 µm and preferably 0.5 µm.

The composition must also include a constituent which functions as a detackifier and is compatible with the polymer portion of the composition. The detackifier reduces the tackiness or stickiness of the composition in order to facilitate and enhance the screening process used to apply the compositions to the predetermined portions of the substrate. This is particularly important since as the fineness of the screens increases, the importance in controlling the tackiness and also the viscosity becomes even more significant.

The component of the composition which has been referred to as the detackifier also functions as a viscosity adjuster to provide the proper viscosity of the composition for the screening application and to render the composition a practical, screenable preparation especially suitable for the intended purposes of the present invention in the preparation of dielectric layers between layers of metal circuitry.

The detackifying component of the composition actually is removed during drying and curing such as by decomposition and vaporization. The detackifying component should not carbonize to an undesired extent and leave a residue on the substrate which would be difficult to remove in subsequent cleaning and removal steps.

It has been found according to the present invention that when the polymer of the film-forming polymer portion is a polyimide/polyamide, the detackifier can be a liquid silicone oil, a drying oil, a terpene or a terpineol. Mixtures of these particular detackifiers can be employed when desired as long as they are compatible with each other.

The detackifier according to the present invention when the film-forming polymer is a polyimide/amide can preferably include the terpenes, such as terpentine. Most preferably, the detackifier is one of the terpineols, such as α-terpineol.

In preparing the screenable composition the polyimide/amides are admixed with the inert diluent prior to admixture with the other components of the composition.

The compositions employed according to the present invention generally have a viscosity of about 0.7 to 50 Pa.s at 25°C. The preferred viscosity of the compositions is about 1 to 13 and the most preferred about 7 to 12.5 Pa.s at 25°C.

The amount of detackifier in the screenable composition is about 1 to 5% by weight and preferably 4.1% by weight.

The weight amount of filler employed relative to the amount of film-forming polymer component in the composition is about 4:6 to 6:4 and preferably about 1:1.

A typical process for employing the screenable composition used for the present invention includes applying the composition through a 360 to 400 mesh screen to a substrate such as a ceramic substrate onto which a layer of metal circuitry is deposited. A ceramic is a product of material manufactured by the action of heat on earthly raw materials. The preferred ceramic substrates include silicon oxides and silicates, such

as aluminum silicate, and aluminum oxides. The metal circuitry consists for example of an about 80 nm thick lower layer of chromium, an about 4 µm thick middle layer of copper and an about 80 nm thick upper layer of chromium.

The coating is generally applied to the substrate in a thickness of about 2.5 to 250 µm and most preferably of about 25 µm. By screen printing this can be easily achieved since this method allows to obtain various predetermined layer thicknesses within small tolerances.

The coated substrates are then dried in order to cause hardening of the coating composition. This is needed to handle the coated substrates. The drying eliminates the tackiness of the surface of the dieletric so that no contamination of the surface with particles can occur. The drying also minimizes the interaction of residual solvent from the polyimide and the solvents contained in the photoresist. The drying is generally conducted at about 75 to 120°C for about 5 to 16 minutes and preferably at about 90°C for 15 minutes. This step can also cause some, if not all, of the decomposition and vaporization of the detackifying component of the composition. The inert filler prevents premature imidization during the drying process.

On the deposited layer a photoresist mask with a hole pattern according to the desired pattern of via holes is formed by using conventional photolithographic techniques. Negative resists like the "Thin Film Resist" marketed by Waycoat or Kodac's KTFR and positive resists like the Shipley 1100 marketed by the Shipley Company can be used. With the photoresist mask as etch mask the via holes are etched into the deposited layer with a potassium hydroxide solution. Preferably a 0.2 molar potassium hydroxide solution is used. Since the thickness of the filled polyimide material in the exposed areas is uniform and since the film polyimide due to the reaction inhibiting effect of the filler is also chemically homogeneous the etched via holes are uniform and have all the same geometric shape. Preferably the via holes have at their lower edge a diameter of about 25 to 50 µm and at their upper edge a diameter of up to about 100 µm. A taper of about 45° of the via hole walls is mostly preferred.

To ensure that during photoresist stripping the filled polyimide layer retains its stability it is baked at 210°C for about 10 to 180 minutes, where 10 minutes are preferred, prior to the resist strip. Subsequently the resist is stripped and then the filled polyimide layer is cured at a temperature between about 300 and 400°C for 15 minutes to 5 hours preferably at 360°C for 30 minutes.

The filled polyimide layer is made between about 2.5 µm and 250 µm and preferably about 25 µm thick. Its surface outside the via holes is essentially planar provided the thickness ratio of the metal circuitry and the filled polyimide does not essentially exceed 1:2. Due to the uniformity of the layer thickness on the one side over the substrate and on the other side over the metal circuitry the concern of the pinhole problem encountered with the known method is eliminated. The cured filled polyimide layer has a good heat conductivity and good dielectric properties.

In order to show that the method according to the invention produced pinhole free dielectric layers, one sample was processed in the same way as described above with the exception that no via holes were formed in it. At one corner of said substrate the filled polyimide was removed in order to be able to make electrical contact to the metal circuits. Then the sample was dipped into an electrolyte and a direct voltage was set to the electrolyte with the sample serving as the cathode. If the filled polyimide layer has pinholes, under these conditions hydrogen bubbles develop, that can be seen with a microscope. Such bubbles did not develop at layers produced by the inventive method.

The heat conductivity is tested by laying a thermo chip, i.e. a chip equipped with a thermo couple, on the cured filled polyimide layer. The temperature increase measured with the thermo couple if a current passes through the metal circuitry covered by the polyimide layer is a measure for the heat conductivity of said layer.

Onto the cured filled polyimide layer a second layer of metal circuitry is formed that preferably consists of the same materials and exhibits the same layer thickness as the metal circuitry deposited on the substrate.

Conventional methods are used i.e. evaporating through a mask or photolithographically where a blanket layer of metal or layers of metal respectively are evaporated either on a photoresist mask followed by a lift-off step or directly on the filled polyimide layer followed by a photolithographic etch process.

To produce structures with a multilayer metal circuitry the above process steps starting with the application of the screenable composition onto the substrate are repeated once or several times.

After the uppermost layer of metal circuitry is formed the then present structure is covered with a passivating layer made from sputtered quartz, plastics or the filled polyimides of the dielectric layer between the metal layers.

The following two examples serve to illustrate preferred embodiments of the inventive method and are not intended to limit the teachings as set forth herein.

## Example 1

The screenable composition used was prepared by taking a solution of 16 g of a polyamidocarboxylic acid, in 84 g N-methyl-2-pyrrolidone (this solution is marketed by DuPont under the tradename PI 2540), and adding to this solution 16 g $Al_2O_3$ particles with a size in the order of 0.5 µm and 5 g α-terpineol which had been premixed by ball-milling for several hours. In addition the whole composition is ball-milled for several hours to ensure uniformity.

This composition was screen coated through a 400 mesh screen onto several square ceramic substrates having a side length of 24, 28 and 36 mm onto which a layer of metal circuitry had been applied. The metal consisted of a lower layer of 80 nm chromium, a middle layer of 4 µm copper and an upper layer of 80 nm chromium. The thickness of the screen coated layer was about 25.4 µm. It followed a drying step for 15 minutes at 90°C. Subsequently a photoresist mask containing a hole pattern corresponding to the desired pattern of via holes was formed from the Shipley 1100 resist by conventional photolithographic steps. With the exception of two samples that were spared for test purposes the samples were then subjected to a solvent etch in 0.2 molar potassium hydroxide solution to remove the filled polyimide in the areas exposed in the mask holes. Subsequently all of the samples were treated at 210°C for 10 minutes and then the photoresist mask was stripped from all the samples followed by the final cure at 380°C for 30 minutes.

The surface of the screen coated layer outside the via hole areas was planar, all the via holes were uniform and had the same geometric shape. The diameter at their lower edge was about 38 µm and at their upper edge about 76 µm. The two samples without the via hole pattern were used to teat the heat conductivity of the screen coated layer and for the search for pinholes. The tests proved the good heat conductivity of the layer and the absence of pinholes in it. Onto the then present structure a second layer of metal circuitry which was similar to the first layer was formed using conventional methods.

The screen coated layer had an excellent adherence to both layers of metal circuitry as found by the scotch tape test. In addition the finished structure showed that the screen coated layer had the same favourable physical and chemical properties as layers made from polyimide only.

Example II

The screenable composition used in this example contained ZnO instead of $Al_2O_3$ as a filler. All the other factors like the amounts of the ingredients, the particle size of the filler, and the process parameters were the same as in example I.

The structures produced in this example had equally favourable properties as the one produced in Example I.

While the invention has been particularly shown and described with reference to the embodiments thereof, it will be understood by those skilled in the art that the foregoing and other changes in form and detail may be made therein without departing from the scope of the invention.

**Claims**

1. A multilayer structure comprising on a substrate at least two layers of interconnected metal circuitry with a polyimide based dielectric layer therebetween containing via holes, characterised in that the dielectric layer comprises a composition containing polyimide and aluminum oxide or zinc oxide or mixtures thereof, wherein the metal:polyimide layer thickness ratio does not exceed 1:2, and the polyimide layer has a planar top surface.

2. The structure of claim 1 wherein the composition contains from about 40 to 60% by weight of polyimide and about 60 to 40% by weight of aluminum oxide or zinc oxide or mixtures thereof.

3. The structure of claim 2 wherein the composition contains about 50% by weight of polyimide and about 50% by weight of aluminum oxide or zinc oxide or mixtures thereof.

4. The structure of claim 1, 2 or 3 wherein the aluminum oxide or zinc oxide or mixtures thereof have a particle size of about 0.25 to about 10 µm.

5. The structure of claim 4, wherein the aluminum oxide or zinc oxide or mixtures thereof have a particle size of about 0.5 µm.

6. A method of producing a multilayer structure comprising at least two interconnected layers of metal circuitry having therebetween a polyimide based dielectric layer containing via holes, characterized by the following process steps:

blanket screen printing a mixture containing a polyamido carboxylic acid, aluminum oxide or zinc oxide or mixtures thereof and a detackifier with the rest being a solvent, like N-methyl-2-pyrrolidone, on a substrate with a layer of metal circuitry thereon, the molecular weight of the polyamido carboxylic acid being in the range from about 500 to about 2500,

drying the deposited layer at temperatures between 75 and 120°C,

applying a photoresist mask,

selectively etching holes into the deposited layer at places where vias between adjacent layers of metal circuitry are needed,

baking at about 210°C before stripping the mask,

curing the deposited layer at a temperature between about 300 and 400°C and forming another layer of metal circuitry.

7. The method of claim 6 wherein the process steps from the screen printing to the depositing of said another layer of metal circuitry are repeated once or several times.

8. The method of claim 6 or 7 wherein said mixture contains from about 10.5 to 16% by weight of said polyamido carboxylic acid and from about 16 to 10.5% by weight of aluminum oxide or zinc oxide or mixtures thereof and about 1 to 5% by weight of the detackifier.

9. The method of claim 8 wherein the mixture contains about 13.2% by weight of said polyamido carboxylic acid, 13.2% by weight of aluminum oxide or zinc oxide or mixtures thereof, 4.1% by weight of detackifier and 69.5% by weight of N-methyl-2-pyrrolidone.

10. The method of claim 6, 7, 8 or 9 wherein said detackifier consists of α-terpineol.

11. The method of claim 10 wherein said substrate consists of a ceramic or a semiconductor.

**Patentansprüche**

1. Vielschichtstruktur, die auf einem Substrat mindestens zwei Schichten einer miteinander verbundenen Metallschaltung mit einer dazwischen angeordneten und Durchgangslöcher enthaltenden dielektrischen Schicht auf Polyimidbasis enthält, dadurch gekennzeichnet, daß die dielektrische Schicht eine Zusammensetzung umfaßt, die Polyimid und Aluminiumoxid oder Zinkoxid oder Gemische davon enthält, wobei das Metall:Polyimidschicht:Dickeverhältnis nicht über 1:2 hinausgeht und die Polyimidschicht eine planare Spitzenoberfläche enthält.

2. Struktur nach Anspruch 1, dadurch gekennzeichnet, daß die Zusammensetzung etwa 40 bis 60 Gew.-% Polyimid und etwa 60 bis 40 Gew.-% Aluminiumoxid oder Zinkoxid oder Gemische davon enthält.

3. Struktur nach Anspruch 2, dadurch gekennzeichnet, daß die Zusammensetzung etwa 50 Gew.-% Polyimid und etwa 50 Gew.-% Aluminiumoxid oder Zinkoxid oder Gemische davon enthält.

4. Struktur nach Anspruch 1, 2 oder 3, dadurch gekennzeichnet, daß das Aluminiumoxid oder Zinkoxid oder die Gemische davon eine Teilchengröße von etwa 0,25 bis etwa 10 μm haben.

5. Struktur nach Anspruch 4, dadurch gekennzeichnet, daß das Aluminiumoxid oder Zinkoxid oder die Gemische davon eine Teilchengröße von etwa 0,5 μm haben.

6. Verfahren zur Herstellung einer Vielschichtstruktur, die mindestens zwei miteinander verbundene Schichten, eine Metallschaltung mit einer dazwischen angeordneten und Durchgangslöcher enthaltenden dielektrischen Schicht auf Polyimidbasis enthält, gekennzeichnet durch die folgenden Verfahrensstufen:

Drucktuchsieb-Aufdrucken eines Gemisches, das eine Polyamidocarbonsäure, Aluminiumoxid oder Zinkoxid oder Gemische davon und ein Antiklebrigmachungsmittel enthält und zum Rest aus einem Lösungsmittel, wie N-Methyl-2-pyrrolidon, besteht, auf ein Substrat mit einer Schicht einer Metallschaltung darauf, wobei das Molekulargewicht der Polyamidocarbonsäure im Bereich von etwa 500 bis etwa 2500 liegt,

Trocknen der abgeschiedenen Schicht bei Temperaturen zwischen 75 und 120°C,

Aufbringen einer Photoresistmaske,

selektive Ätzung von Löchern in die abgeschiedene Schicht an Stellen, wo Durchgänge zwischen angrenzenden Schichten der Metallschaltung benötigt werden,

Brennen bei etwa 210°C, bevor die Maske abgestreift wird,

Härten der abgeschiedenen Schicht bei einer Temperatur zwischen etwa 300 und 400°C und Bildung einer weiteren Schicht der Metallschaltung.

7. Verfahren nach Anspruch 6, dadurch gekennzeichnet, daß die Verfahrensstufen vom Siebbedrucken zu der Abscheidung der genannten weiteren Schicht der Metallschaltung ein- oder mehrmals wiederholt werden.

8. Verfahren nach Anspruch 6 oder 7, dadurch gekennzeichnet, daß das Gemisch etwa 10,5 bis 16 Gew.-% Polyamidocarbonsäure und etwa 16 bis 10,5 Gew.-% Aluminiumoxid oder Zinkoxid oder Gemische davon und etwa 1 bis 5 Gew.-% Antiklebrigmachungsmittel enthält.

9. Verfahren nach Anspruch 8, dadurch gekennzeichnet, daß das Gemisch etwa 13.2 Gew.-% Polyamidocarbonsäure, 13,2 Gew.-% Aluminiumoxid oder Zinkoxid oder Gemische davon, 4,1 Gew.-% Antiklebrigmachungsmittel und 69,5 Gew.-% N-Methyl-2-pyrrolidon enthält.

10. Verfahren nach Anspruch 6, 7, 8 oder 9, dadurch gekennzeichnet, daß das Antiklebrigmachungsmittel aus α-Terpineol besteht.

11. Verfahren nach Anspruch 10, dadurch gekennzeichnet, daß das Substrat aus einer Keramik oder einem Halbleiter besteht.

**Revendications**

1. Structure multicouche comprenant sur un substrat au moins deux couches de circuits métalliques interconnectés, séparées par une couche diélectrique à base de polyimide contenant des trous de liaison, caractérisée en ce que la couche diélectrique comprend une composition contenant un polyimide et de l'oxyde d'aluminium ou de l'oxyde de zinc ou des mélanges de ceux-ci, dans laquelle le rapport d'épaisseur métal:couche de polyimide ne dépasse pas 1:2 et la couche de polyimide a une surface supérieure plane.

2. Structure suivant la revendication 1, dans laquelle la composition contient d'environ 40 à 60% en poids de polyimide et d'environ 60 à 40% en poids d'oxyde d'aluminium ou d'oxyde de zinc ou de leurs mélanges.

3. Structure suivant la revendication 2, dans laquelle la composition contient environ 50% en poids de polyimide et environ 50% en poids d'oxyde d'aluminium ou d'oxyde de zinc ou de leurs mélanges.

4. Structure suivant les revendications 1, 2 ou 3, dans laquelle l'oxyde d'aluminium ou l'oxyde de zinc ou leurs mélanges ont une dimensions particulaire d'environ 0,25 μm à environ 10 μm.

5. Structure suivant la revendication 4, dans laquelle l'oxyde d'aluminium ou l'oxyde de zinc ou leurs mélanges ont une dimension particulaire d'environ 0,5 µm.

6. Méthode de production d'une structure multicouche comprenant au moins deux couches interconnectées de circuits métalliques séparées par une couche diélectrique à base de polyimide contenant des trous de liaison, caractérisée par les étapes de traitement suivantes:

impression en couverture à travers un écran avec un mélange contenant un acide polyamido-carboxylique, de l'oxyde d'aluminium ou de l'oxyde de zinc ou leurs mélanges et un agent détackifiant, le reste étant un solvant comme la M-méthyl-2-pyrrolidone, sur un substrat portant une couche de circuit métallique, le poids moléculaire de l'acide polyamido-carboxylique étant dans la gamme d'environ 500 à 2500,

séchage de la couche déposée à des températures comprises entre 75 et 120°C,

application d'un masque de photorésist,

attaque chimique sélective formant des trous dans la couche déposée aux endroits où des liaisons entre des couches adjacentes de circuits métalliques sont nécessaires,

cuisson à environ 210°C avant élimination du masque,

durcissement de la couche déposée à une température comprise entre environ 300 et 400°C et formation d'une outre couche de circuit métallique.

7. Méthode suivant la revendication 6, dans laquelle les étapes de traitement allant de l'impression à travers un écran jusqu'au dépôt de cette autre couche de circuit métallique sont répétées une ou plusieurs fois.

8. Méthode suivant la revendication 6 ou 7, dans laquelle ce mélange contient d'environ 10,5 à 16% en poids de cet acide polyamido-carboxylique et d'environ 16 à 10,5% en poids d'oxyde d'aluminium ou d'oxyde de zinc ou de leurs mélanges et d'environ 1 à 5% en poids de l'agent détackifiant.

9. Méthode suivant la revendication 8, dans laquelle ce mélange contient environ 13,2% en poids de cet acide polyamido carboxylique et environ 13,2% en poids d'oxyde d'aluminium ou d'oxyde de zinc ou de leurs mélanges, 4,1% en poids d'agent détackifiant et 69,5% en poids de N-méthyl-2-pyrrolidone.

10. Méthode suivant la revendications 6, 7, 8 ou 9, dans laquelle cet agent détackifiant consiste en α-terpinéol.

11. Méthode suivant la revendication 10, dans laquelle ce substrat consiste en une céramique ou un semi-conducteur.